# EUROPEAN PATENT SPECIFICATION

(11) **EP 3 435 407 B1**
(45) Date of publication and mention of the grant of the patent: **20.11.2024**
(21) Application number: 17770079.6
(22) Date of filing: 15.03.2017
(51) Int. Cl.: H01L 21/205, C23C 16/34, C30B 25/14, C30B 29/38, C30B 25/16, C30B 25/18, C30B 29/40, H01L 21/02

(54) **METHOD FOR PRODUCING GROUP III NITRIDE LAMINATE**
VERFAHREN ZUR HERSTELLUNG EINES GRUPPE-III-NITRID-LAMINATS
PROCÉDÉ DE PRODUCTION D'UN STRATIFIÉ DE NITRURE DU GROUPE III

(30) Priority: 24.03.2016 JP 2016060197
(43) Date of publication of application: 30.01.2019
(73) Proprietor: Stanley Electric Co., Ltd., Meguro-ku Tokyo 153-8636 (JP)
(72) Inventor: FURUYA, Hiroshi, Shunan-shi, Yamaguchi 745-8648 (JP)
(74) Representative: Canzler & Bergmeier Patentanwälte Partnerschaft mbB
(86) International application number: PCT/JP2017/010408
(87) International publication number: WO 2017/164036

(56) References cited:
- EP-A1- 2 500 451
- EP-A1- 3 267 497
- JP-A- 2003 023 220
- JP-A- 2006 080 378
- JP-A- 2006 080 378
- JP-A- 2010 232 364
- JP-A- 2013 187 428
- JP-A- 2014 017 422
- JP-A- 2014 103 211
- JP-A- 2015 115 366
- JP-A- 2016 039 325
- OKADA ET AL: "Growth of high-quality and crack free AlN layers on sapphire substrate by multi-growth mode modification", JOURNAL OF CRYSTAL GROWTH, ELSEVIER, AMSTERDAM, NL, vol. 298, 13 February 2007 (2007-02-13), pages 349 - 353, XP005864039, ISSN: 0022-0248, DOI: 10.1016/J.JCRYSGRO.2006.10.123
- HIRAYAMA H ET AL: "222 nm Deep-Ultraviolet AlGaN Quantum Well Light-Emitting Diode with Vertical Emission Properties", APPLIED PHYSICS EXPRESS, JAPAN SOCIETY OF APPLIED PHYSICS; JP, JP, vol. 3, no. 3, 5 March 2010 (2010-03-05), pages 32102 - 1, XP001554259, ISSN: 1882-0778, [retrieved on 20100305], DOI: 10.1143/APEX.3.032102

## Description

### TECHNICAL FIELD

The present invention relates to a novel method for producing a group III nitride laminate applicable to an ultraviolet light emitting device and the like. The invention also relates to a novel method for manufacturing a group III nitride semiconductor including an n-type layer, an active layer, and a p-type layer formed on the group III nitride laminate.

### BACKGROUND ART

Light sources which emit light in the ultraviolet region are utilized in a wide range of fields such as sterilization, medical treatment, and analytical instruments. Mercury lamps, deuterium lamps, and the like are used as existing ultraviolet light sources, but such light sources have problems such as a short life span, a great size, and the environmental burden due to use of mercury. Hence, a light source having a long life span, a small size, and low environmental burden while having the same emission wavelength is desired.

A group III nitride semiconductor represented by a composition formula AlInGaN has a direct transition-type band structure in all composition ranges, and an arbitrary emission peak wavelength can be selected in the deep ultraviolet region by controlling the composition of group III elements (Al, In, and Ga). Hence, the group III nitride semiconductor is an optimum material for forming an ultraviolet light emitting device. Particularly, a group III nitride semiconductor having high Al composition in a range of 0.8 (Al composition: 80%) or more is optimum as a material of a device which emits light in a deep ultraviolet region having a wavelength of from 200 to 350 nm.

Generally, a group III nitride laminate is produced by forming a group III nitride semiconductor layer on a single crystal substrate by a metal organic chemical vapor deposition method (MOCVD method), a molecular beam epitaxy method (MBE method), a hydride vapor phase epitaxy method (HVPE method) or the like. Generally, an active layer which is a light emitting layer of a light emitting device equipped with a group III nitride semiconductor has an extremely fine structure in which semiconductor layers having a film thickness of several nm are laminated, and the steepness of the interface between the laminated semiconductor layers greatly affects the characteristics of the light emitting device. Hence, it is extremely important to improve the smoothness of the surface of the group III nitride laminate in order to manufacture a light emitting device exhibiting excellent characteristics.

It has been reported that a deep ultraviolet light emitting device which emits light having an emission wavelength of 222 nm can be manufactured by, for example, forming a light emitting layer on an n-typeAlGaN layer having Al composition of 89% (see Non-Patent Document 1). In addition to this, a method for producing n-type AlGaN which has high Al composition and is optimum for a deep ultraviolet light emitting device is also disclosed (see Patent Document 1).

### CITATION LIST

### Patent Documents

Patent Document 1: JP 2014-73918 A;
Patent Document 2 : EP 3 267 497 A1;
Patent Document 3 : EP 2 500 451 A1;
Patent Document 4 : JP 2006 080378 A.

### Non-patent documents

Non-Patent Document 1: Hirayama et al.: "222 nm Deep-Ultraviolet AlGaN Quantum Well Light-Emitting Diode with Vertical Emission Properties", Appl. Phys. Express, Japan Society of Applied Physics; JP, vol. 3, no. 3, 5 March 2010, pages 032102-1 to 032102-3;
Non-Patent Document 2: Okada et al.: "Growth of high-quality and crack free AIN layers on sapphire substrate by multi-growth mode modification", Journal of Crystal Growth, Elsevier, Amsterdam, NL, vol. 298, 13 February 2007, pages 349 to 353.

### SUMMARY OF THE INVENTION

### PROBLEM TO BE SOLVED BY THE INVENTION

However, in Non-Patent Document 1, details on the method for producing the n-type AlGaN layer having Al composition of 89% are not described and the optimum growth condition is unclear. In addition, the smoothness of the n-type AlGaN layer and the group III nitride semiconductor layer formed on the n-type AlGaN layer has not been reported.

In addition, in Patent Document 1, a method for producing n-type AlGaN which has high Al composition and is optimum for a deep ultraviolet light emitting device is disclosed, but the Al composition is limited to from 60% to 80%, and it has been suggested that it is difficult to produce high quality n-type AlGaN having Al composition of 80% or more. Moreover, in Patent Document 1, it is described that the V/III ratio which is the molar ratio of the nitrogen source gas to the group III raw material gas at the time of the growth of n-type AlGaN is set to be in a range of from 800 to 4000 in order to produce n-type AlGaN which has high Al composition and exhibits favorable smoothness. In Examples of Patent Document 1, n-type AlGaN having Al composition of 70% is produced.

At a glance, it is considered that the group III nitride semiconductor layer having high Al composition can easily grow since the composition is close in a case that a group III nitride semiconductor layer having high Al composition grows on an aluminum nitride single crystal layer.

However, in the investigations by the inventors of the invention, it has been found that a surface shape having minute undulations is formed and the surface smoothness is not sufficient as a deep ultraviolet light emitting device exerting advanced characteristics in a case that the method described in Patent Document 1 is actually adopted and the V/III ratio is set to from 800 to 4000 in the growth of a group III nitride semiconductor having high Al composition of 80% or more and Al composition of further more than 80%. These minute undulations indicate that crystal growth has proceeded in the Stranski-Krastanov (SK) mode or Volmer-Weber (VW) mode. Hence, it is required to proceed the crystal growth in the Frank van der Merwe (FM) mode in order to form a smooth surface.

Accordingly, the known technique is insufficient in order to grow the group III nitride semiconductor which has high Al composition of 80% or more and exhibits excellent smoothness, and it is required to investigate the optimum growth condition for proceeding the crystal growth in the FM mode.

Patent Document 2, which is an intermediate document according to Article 54(3) EPC, discloses a method for producing a group III nitride laminate which comprises, on an AlN single crystal substrate, a multilayer structure having an Al_{X}Ga_{1-X}N layer (0 < X ≤ 1) that is lattice-matched to the AlN single crystal substrate, and wherein a GaN layer that has a film thickness of 5-400 nm and a dislocation density of less than 5 × 10¹⁰ cm⁻² or a half width of the X-ray omega rocking curve of 50-300 seconds is laminated on the Al_{X}Ga_{1-X}N layer (0 < X ≤ 1). The V/III ratio representing a molar ratio of the nitrogen source gas to the group III raw material gas is set to 5000.

Patent Document 3 intends to solve the technical problem of stably carrying out a group III polarity growth on the sapphire substrate. For solving this problem, the inventors suggest a production method of a layered body having a single crystal layer comprising a group III nitride on a sapphire substrate by MOCVD. More specifically, it is an essential step to supply a group III raw material gas and nitrogen source gas as well as oxygen source gas onto the sapphire substrate prior to growing the AlGaInN layer, to thereby forming an initial single crystal layer comprising the group III nitride containing oxygen.

Patent Document 4 and Non-Patent Document 2 also relate to epitaxial growing on a sapphire substrate, onto which a AllnGaN layer is grown.

In view of the above, an object of the invention is to provide a method for producing a group III nitride laminate exhibiting excellent surface smoothness by growing a layer containing a group III nitride single crystal (hereinafter simply referred to as the "Al_{X}In_{Y}Ga_{Z}N layer" in some cases) represented by a composition formula of Al_{X}In_{Y}Ga_{Z}N (X + Y + Z = 1.0, 0.85 ≤ X < 0.99, 0.00 ≤ Y < 0.14, and 0.01 < Z ≤ 0.15) onto a main surface of a base substrate of which at least one main surface contains an aluminum nitride single crystal layer.

Furthermore, an object of the invention is to provide a method for manufacturing a group III nitride semiconductor which exhibits excellent interface steepness and can be applied as an ultraviolet light emitting device by forming, if necessary an n-type layer, on such a group III nitride laminate exhibiting excellent surface smoothness and then forming an active layer and a p-type layer thereon.

### MEANS FOR SOLVING PROBLEM

The inventors of the invention have conducted intensive investigations in order to solve the above problems. Specifically, the growth conditions when growing the group III nitride single crystal layer represented by a composition formula of Al_{X}In_{Y}Ga_{Z}N (X + Y + Z = 1.0, 0.85 ≤ X < 0.99, 0.00 ≤ Y < 0.14, and 0.01 < Z ≤ 0.15) on a base substrate having the surface aluminum nitride single crystal layer have been investigated, and as a result, it has been found out that a group III nitride laminate exhibiting extremely excellent surface smoothness is obtained when the flow ratio of raw material gas and the growth rate are in specific ranges, whereby the invention has been completed.

In other words, according to a first aspect of the invention a method for producing a group III nitride laminate according to claim 1 is suggested.

In addition, in the first aspect of the invention, an excellent effect is exerted in a case that the layer containing the group III nitride single crystal contains a dopant.

Furthermore, a second aspect of the invention is a method for manufacturing the group III nitride semiconductor, which includes producing a group III nitride laminate according to the method for producing the group III nitride laminate of the first aspect of the invention and then forming at least an active layer and a p-type layer on the group III nitride single crystal layer.

### EFFECT OF THE INVENTION

According to the invention, it is possible to fabricate the group III nitride laminate which has high Al composition, is suitable as a material of an ultraviolet light emitting device, and exhibits excellent surface smoothness by growing the layer containing a group III nitride single crystal in a specific range of growth condition and thus controlling the crystal growth mode.

In addition, according to the method of the invention, it is possible to manufacture the group III nitride semiconductor exhibiting excellent characteristics such as surface smoothness by further forming arbitrary group III nitride single crystal layers on the group III nitride laminate exhibiting excellent surface smoothness.

### BRIEF DESCRIPTION OF DRAWINGS

- **FIG. 1**: is a schematic diagram illustrating one aspect of a process producing the group III nitride laminate;
- **FIG. 2**: is a schematic diagram illustrating one aspect of a process manufacturing the group III nitride semiconductor;
- **FIG. 3**: is a diagram illustrating a surface morphology of a surface of the group III nitride laminate produced in Example 2 measured by using an atomic force microscope (field of vision: 2 × 2 µm²);
- **FIG. 4**: is a diagram illustrating a surface morphology of a surface of the group III nitride laminate produced in Comparative Example 1 measured by using an atomic force microscope (field of vision: 2 × 2 µm²);
- **FIG. 5**: is a diagram illustrating a surface morphology of a surface of an active layer of the group III nitride semiconductor manufactured in Example 4 measured by using an atomic force microscope (field of vision: 2 × 2 µm²); and
- **FIG. 6**: is a diagram illustrating a surface morphology of a surface of an active layer of the group III nitride semiconductor manufactured in Comparative Example 3 measured by using an atomic force microscope (field of vision: 2 × 2 µm²).

### MODE FOR CARRYING OUT THE INVENTION

The method of the invention is for producing a group III nitride laminate by supplying a group III raw material gas and a nitrogen source gas onto main surface of a base substrate of which at least one main surface contains an aluminum nitride single crystal layer and growing a layer containing a group III nitride single crystal represented by Al_{X}In_{Y}Ga_{Z}N, where X, Y, and Z in the composition formula satisfy the relation of X + Y + Z = 1.0, 0.85 ≤ X < 0.99, 0.00 ≤ Y < 0.14, and 0.01 < Z ≤ 0.15 under a specific condition. Hereinafter, embodiments of the invention will be described in detail.

### (Base substrate)

In the invention, the base substrate which is aluminium nitride single crystal substrate is not particularly limited, but it is preferable to use one in which the aluminum nitride single crystal layer of the one main surface has a low dislocation density. Specifically, the dislocation density is preferably 10⁶ cm⁻² or less and still more preferably 10⁶ cm⁻² or less. By using a base substrate including an aluminum nitride single crystal layer having a low dislocation density as a main surface, it is possible to suppress a change in crystal growth mode derived from dislocation and to fabricate a group III nitride laminate having a smoother surface.

In addition, in the invention, the crystal growth surface of the base substrate, namely, the main surface containing the aluminum nitride single crystal layer is not particularly limited as long as it can realize the structure of the invention, but a c-plane is preferable from the viewpoint of enhancing the smoothness of the Al_{X}In_{Y}Ga_{Z}N layer (X + Y + Z = 1.0, 0.85 ≤ X < 0.99, 0.00 ≤ Y < 0.14, and 0.01 < Z ≤ 0.15). Furthermore, it is preferably an Al polar surface. In addition, the main surface may be a surface slightly inclined (off) from the c-plane, and in that case, the off angle is preferably from 0.1° to 1° and more preferably from 0.1° to 0.5°. It is preferable that the surface is further inclined in the m-axis direction. By forming a main surface having an off angle, bunching of atomic steps hardly occurs and step flow growth easily occurs. As a result, the smoothness of the group III nitride single crystal layer to grow on the base substrate is improved.

In addition, in the invention, it is preferable that the crystal growth surface of the base substrate, namely, the main surface containing the aluminum nitride single crystal layer is smooth. It is possible to diminish the occurrence of new dislocation at the growth interface between the base substrate and the group III nitride single crystal layer to be laminated on the base substrate and to obtain a group III nitride laminate having a smoother surface shape, since the crystal growth surface is smooth. Specifically, the root-mean-square roughness (RMS) in a region of 2 × 2 µm² measured by using an atomic force microscope is preferably 5 nm or less, more preferably 1 nm or less, and still more preferably 0.5 nm or less. In order to form such a smooth surface, the crystal growth surface of the base substrate may be polished by a known method such as chemical mechanical polish.

In addition, damage of the crystal growth surface of the base substrate is required to be diminished as much as possible since there is a risk that new dislocation occurs in the Al_{X}In_{Y}Ga_{Z}N layer (X + Y + Z = 1.0, 0.85 ≤ X < 0.99, 0.00 ≤ Y < 0.14, and 0.01 < Z ≤ 0.15) from the damage as a starting point and the surface smoothness deteriorates in a case that damage due to polishing or the like remains on the crystal growth surface (main surface) of the base substrate. Such polishing damage can be removed by a known alkali or acid etching treatment. Moreover, it is preferable that the pit density on the main surface to be newly formed after etching is small. This pit is formed at the dislocation or damage-remaining place of the aluminum nitride single crystal layer. The pit density on the crystal growth surface (main surface) of the base substrate is preferably 5 pieces/mm² or less and more preferably 2 pieces/mm² or less. In addition, as a matter of course, the polishing scratches or the like are also required to be diminished as much as possible, and the number of polishing scratches is preferably 0 piece/substrate.

The thickness, size, and shape of the base substrate to be used in the invention are not particularly limited. It is preferable that the thickness of the base substrate is usually from 50 to 1000 µm since it is difficult to handle the base substrate and the possibility of being broken during handling increases when the thickness is too thin. With regard to the size of the base substrate, large size is preferable, since the number of devices to be obtained increases as the size is larger when considering the fabrication of group III nitride laminate as a material of a light emitting device. However, one having a circular shape having a diameter of from φ 0.5 to φ 6 inches or one having a polygonal shape having the longest diagonal line of from 0.5 to 300 mm is preferable when considering industrial production.

As the base substrate as described above, a base substrate produced by a known method can be used. For example, a so-called template in which an aluminum nitride single crystal layer is formed on a heterogeneous substrate such as a sapphire substrate or a SiC substrate by a chemical vapor deposition method or the like can be used as the base substrate. In addition, the base substrate may be a single-layer aluminum nitride single crystal substrate obtained by thickening the aluminum nitride single crystal layer on the template and then removing the heterogeneous substrate. In addition, it is also possible to use an aluminum nitride single crystal substrate fabricated by appropriately cutting and polishing a bulk aluminum nitride single crystal fabricated not only by the chemical vapor deposition method but also by a known crystal growth method such as a sublimation method or a flux method. The method for producing the base substrate is not particularly limited, but it is preferable to use an aluminum nitride single crystal substrate as the base substrate from the viewpoint of the dislocation density described above since an aluminum nitride single crystal layer grown on a heterogeneous substrate contains a large number of dislocations.

In addition, in the invention, it is preferable that the base substrate is appropriately cleaned before growing the layer containing a group III nitride single crystal thereon. An oxide film is formed on the surface of the aluminum nitride single crystal layer and there is a possibility that the oxide film inhibits the crystal growth and the surface smoothness of the group III nitride laminate to be obtained deteriorates. In such a case, it is possible to form the surface of an aluminum nitride layer suitable for crystal growth by performing cleaning using phosphoric acid or the like for the purpose of removing the oxide film.

In addition, there is a possibility that organic substances and inorganic substances are attached to the surface of the base substrate when handling the base substrate in the polishing step and the like. As a matter of course, the attachment of such substances is required to be diminished as much as possible. Such attached substances can also be removed by cleaning. The organic substances can be removed by cleaning using an organic solvent such as acetone or isopropyl alcohol. Inorganic substances can be removed by cleaning such as scrub cleaning. The method of cleaning the base substrate is not particularly limited, and any known method may be used depending on the purpose.

**(Al_{X}In_{Y}Ga_{Z}N layer (X + Y + Z = 1.0, 0.85 ≤ X < 0.99, 0.00 ≤ Y < 0.14, and 0.01 < Z ≤ 0.15))**

In the invention, the Al_{X}In_{Y}Ga_{Z}N layer (X + Y + Z = 1.0, 0.85 ≤ X < 0.99, 0.00 ≤ Y < 0.14, and 0.01 < Z ≤ 0.15) is a layer containing the group III nitride single crystal grown on main surface 11a of a base substrate 11 of which at least one main surface contains an aluminum nitride single crystal layer. Hereinafter, the Al_{X}In_{Y}Ga_{Z}N layer (X + Y + Z = 1.0, 0.85 ≤ X < 0.99, 0.00 ≤ Y < 0.14, and 0.01 < Z ≤ 0.15) is simply referred to as an Al_{X}In_{Y}Ga_{Z}N layer in some cases unless otherwise stated, specifically, in a case that the numerical values of X, Y, and Z are not particularly limited.

The Al_{X}In_{Y}Ga_{Z}N layer can contain an n-type or p-type dopant for the purpose of controlling the conductivity. As the n-type or p-type dopant, known elements can be used without limitation, but it is preferable to use Si as the n-type dopant and Mg as the p-type dopant. The dopant concentration is not particularly limited and may be appropriately determined depending on the purpose. As a matter of course, the Al_{X}In_{Y}Ga_{Z}N layer may be an undoped Al_{X}In_{Y}Ga_{Z}N layer.

In the invention, the composition of the Al_{X}In_{Y}Ga_{Z}N layer, specifically, X, Y, and Z satisfy that X + Y + Z = 1.0, 0.85 ≤ X < 0.99, 0.00 ≤ Y < 0.14, and 0.01 < Z ≤ 0.15. The values of X, Y, and Z may be appropriately determined depending on the intended use of the light emitting device or the like. However, the production method of the invention can be suitably applied to a case that the Al composition is higher and the composition ratio of Ga, In, and the like is small. Hence, to further exert the effect of the invention, it is preferred that X + Y + Z = 1.0 is satisfied and 0.88 ≤ X ≤ 0.97, 0.00 ≤ Y ≤ 0.09, and 0.03 ≤ Z ≤ 0.12. The Al_{X}In_{Y}Ga_{Z}N layer may be a single layer or a multilayer as long as the above composition is satisfied. In addition, the Al_{X}In_{Y}Ga_{Z}N layer may be a graded composition layer of which the composition continuously changes in the above composition range.

In addition, it is preferable that the Al_{X}In_{Y}Ga_{Z}N layer has a small amount of carbon impurities. For example, there is a possibility that deterioration in conductivity and permeability is caused when carbon contaminant in the Al_{X}In_{Y}Ga_{Z}N layer is large, and thus the carbon concentration in the Al_{X}In_{Y}Ga_{Z}N layer is preferably 10¹⁷ cm⁻³ or less and more preferably 5 × 10¹⁶ cm⁻³ or less.

In addition, the film thickness of the Al_{X}In_{Y}Ga_{Z}N layer is not particularly limited and may be appropriately determined depending on the purpose of use, but it is preferable that the film thickness is in a range of from 0.01 to 10 µm since it is considered that the Al_{X}In_{Y}Ga_{Z}N layer cannot be lattice-matched with the aluminum nitride single crystal substrate when the Al_{X}In_{Y}Ga_{Z}N layer is too thick in the case of using an aluminum nitride single crystal substrate as the base substrate.

According to the method of the invention, it is possible to further smooth the surface of the Al_{X}In_{Y}Ga_{Z}N layer. Hence, the group III nitride laminate (the laminate having the Al_{X}In_{Y}Ga_{Z}N layer on the base substrate) produced by the method of the invention is suitably utilized as the material of an ultraviolet light emitting device. It is possible to suppress deterioration in smoothness and crystal quality of the semiconductor layer (for example, an n-type layer, an active layer, and a p-type layer to be formed if necessary) which further grows on the group III nitride laminate when manufacturing an ultraviolet light emitting device, since the surface of the Al_{X}In_{Y}Ga_{Z}N layer is smooth. Moreover, as a result, it is possible to fabricate a higher quality ultraviolet light emitting device. According to the method of the invention, it is possible to reduce the RMS of the Al_{X}In_{Y}Ga_{Z}N layer, specifically, in a region of 2 × 2 µm² measured by using an atomic force microscope to 5 nm or less, preferably to 1 nm or less, and still more preferably to 0.5 nm or less.

According to the method of the invention, it is possible to form an Al_{X}In_{Y}Ga_{Z}N layer which satisfies the RMS range and has a surface (main surface) not having minute undulations. As described in Comparative Examples, minute undulations (island-shaped undulations) having a size (maximum length) of about from 0.3 to 1.0 µm are observed on the main surface under an atomic force microscope in a case that the conditions of the production method of the invention are not satisfied. According to the invention, it is possible to obtain a significantly smooth surface (main surface) so that clear island-shaped undulations as in Comparative Example are not observed or island-shaped undulations are not observed at all.

In addition, a hillock having a size of several µm may be formed on the outermost surface of the Al_{X}In_{Y}Ga_{Z}N layer in some cases. Such a hillock causes deterioration in surface flatness of the semiconductor layer which further grows on the group III nitride laminate and deterioration in the crystal quality and causes breakdown of the ultraviolet light emitting device fabricated. According to the method of the invention, such a hillock can also be decreased. According to the invention, it is possible to reduce the hillock density on the outermost surface of the Al_{X}In_{Y}Ga_{Z}N layer to 10 pieces/mm² or less, preferably to 5 pieces/mm² or less, more preferably 1 piece/mm² or less, and still more preferably 0 piece/mm². Incidentally, in the invention, the hillock density can be measured by surface observation under a Nomarski type differential interference microscope. It is not possible to observe this hillock under an atomic force microscope since it is much higher than the minute undulations.

Next, the growth condition of the layer (Al_{X}In_{Y}Ga_{Z}N layer) containing the group III nitride single crystal represented by Al_{X}In_{Y}Ga_{Z}N, which is the characteristic feature of the invention will be described.

**(Method of growing Al_{X}In_{Y}Ga_{Z}N layer (X + Y + Z = 1.0, 0.85 ≤ X < 0.99, 0.00 ≤ Y < 0.14, and 0.01 < Z ≤ 0.15))**

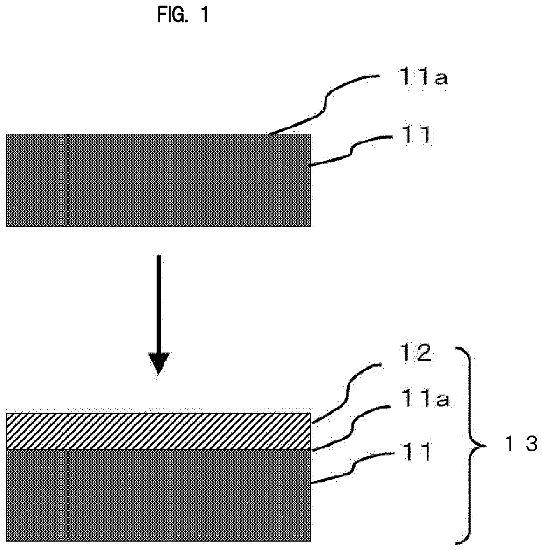

The method for producing a group III nitride laminate of the invention is for producing a group III nitride laminate in which an Al_{X}In_{Y}Ga_{Z}N layer (group III nitride single crystal layer) is laminated on main surface of a base substrate of which at least one main surface contains an aluminum nitride single crystal layer. Fig. 1 is a schematic diagram illustrating one aspect of the process of producing a group III nitride laminate, and a group III nitride laminate 13 is produced by depositing a group III nitride single crystal layer 12 (Al_{X}In_{Y}Ga_{Z}N layer) on the main surface 11a of a base substrate 11 of which at least one main surface contains an aluminum nitride single crystal layer as illustrated in Fig. 1. A group III raw material gas and a nitrogen source gas which are used for growing the group III nitride single crystal layer 12 are supplied onto the main surface 11a.

In the invention, the method of growing the Al_{X}In_{Y}Ga_{Z}N layer is not particularly limited, but it is preferable to adopt a MOCVD method exhibiting excellent ability to control the growth rate and the raw material supply ratio. In the case of adopting a MOCVD method, the crystal growth conditions other than the conditions (V/III ratio) specified in the invention such as the kinds of raw material gas and carrier gas are not particularly limited and may be appropriately set depending on the group III nitride single crystal desired.

Specifically, in the case of adopting a MOCVD method, examples of the group III raw material gas may include trimethylaluminum, trimethylgallium, and trimethylindium. In addition, examples of the nitrogen source gas (group V raw material gas) may include ammonia. The above raw material gases and a hydrogen gas, a nitrogen gas and the like as a carrier gas may be introduced into the MOCVD apparatus.

In addition, a dopant raw material gas may be introduced into the MOCVD apparatus at the same time with the group III raw material gas and the nitrogen source gas (group V raw material gas) in a case that the Al_{X}In_{Y}Ga_{Z}N layer is an n-type or p-type layer. Examples of the raw material gas of the n-type dopant may include monosilane and tetraethylsilane, and examples of the raw material gas of the p-type dopant may include biscyclopentadienyl magnesium.

In the invention, the supply molar ratio (V/III ratio) of the nitrogen source gas (group V raw material gas) to the group III raw material gas when growing the Al_{X}In_{Y}Ga_{Z}N layer (group III nitride single crystal layer) is set to 5000 or more and 15000 or less.

When the V/III ratio is less than 5000, a surface shape having minute undulations is formed and the surface smoothness deteriorates in a case that an Al_{X}In_{Y}Ga_{Z}N layer having Al composition of 0.8 or more is grown although a change in the mode of crystal growth is considered as a cause.

On the other hand, when the V/III ratio is more than 15000, the reaction between the group III raw material and the nitrogen source gas (group V raw material) in the vapor phase is remarkable and substances generated by the reaction in the vapor phase are attached to the growth surface to deteriorate the surface smoothness. Furthermore, the growth rate tends to markedly decrease and it is not suitable for industrial production.

Consequently, the V/III ratio is preferably 6000 or more and 15000 or less and more preferably 6000 or more and 12000 or less when these points are taken into consideration. Incidentally, the number of moles is sum of respective group III raw material gases for forming the Al_{X}In_{Y}Ga_{Z}N layer containing Al, Ga, and In as a matter of course.

During the growth of the Al_{X}In_{Y}Ga_{Z}N layer (group III nitride single crystal layer), the V/III ratio may be constant or may be changed by changing the supply amount of the group III raw material gas or the nitrogen source gas (group V raw material gas). However, it is required to adjust the supply amount so that the V/III ratio satisfies the range of 5000 or more and 15000 or less even in the case of changing the supply amount. In addition, in the growth of the Al_{X}In_{Y}Ga_{Z}N layer (group III nitride single crystal layer), the composition of the group III raw material gas may be changed. In other words, it is possible to grow Al_{X}In_{Y}Ga_{Z}N layers having different compositions by changing the composition ratios of trimethylaluminum, trimethylgallium, and trimethylindium which are group III raw material gases. In addition, it is possible to obtain a graded composition layer in which the group III composition continuously changes by continuously changing the composition of the group III raw material gas.

In the invention, the growth rate when growing the Al_{X}In_{Y}Ga_{Z}N layer (group III nitride single crystal layer) is not particularly limited but is preferably set to 0.1 µm/h or more and 0.5 µm/h or less. In a case that the growth rate is too fast than 0.5 µm/h when growing the Al_{X}In_{Y}Ga_{Z}N layer (group III nitride single crystal layer), that is, the supply amount of the group III raw material gas is large, island-shaped crystal nucleuses are formed at the initial stage of growth, the crystals are likely to grow in a SK mode or a VW mode, and the smoothness of the surface tends to deteriorate. On the other hand, in a case that the growth rate is slower than 0.1 µm/h, that is, the supply amount of the group III raw material gas is too small, the influence of the decomposition of the group III nitride single crystal, which competitively proceeds with the growth increases and the smoothness tends to deteriorate. In addition, it is not preferable that the growth rate is too slow from the viewpoint of productivity as well. The growth rate when growing the Al_{X}In_{Y}Ga_{Z}N layer (group III nitride single crystal layer) is more preferably in a range of 0.1 µm/h or more and 0.4 µm/h or less and still more preferably in a range of 0.2 µm/h or more and 0.3 µm/h or less when these points are taken into consideration.

Incidentally, in the invention, the growth rate when growing the Al_{X}In_{Y}Ga_{Z}N layer (group III nitride single crystal layer) can be controlled not only by the supply amounts of raw materials but also by various growth conditions such as the growth temperature, the pressure in the reaction furnace, and the flow rate of the carrier gas at the time of crystal growth. The method of controlling the growth rate is not particularly limited, but it is usual to control the growth rate by the supply amounts of raw materials since it is preferable to determine the conditions of crystal growth with considering the quality of the group III nitride single crystal layer.

In the invention, the growth temperature (temperature of the main surface of the base substrate) when growing the Al_{X}In_{Y}Ga_{Z}N layer (group III nitride single crystal layer) is preferably in a range of 1000°C or more and 1200°C or less. The crystal quality can be improved, and additionally, the growth rate is easily adjusted when the growth temperature satisfies this range. When the growth temperature is lower than 1000°C, the crystal quality is deteriorated, and the diffusion of the raw material atoms is insufficient to cause deterioration in smoothness. On the other hand, when the growth temperature is much higher than 1200°C, more defects are generated in the crystal and the deterioration in the crystal quality is likely occurred. In addition, when the Al_{X}In_{Y}Ga_{Z}N layer (group III nitride single crystal layer) contains Ga, detachment of Ga is promoted at a high temperature of more than 1200°C and it is difficult to control the composition in some cases. The growth temperature is preferably in a range of 1050°C or more and 1150°C or less and still more preferably in a range of 1050°C or more and 1100°C or less when these points are taken into consideration.

A laminate exhibiting excellent crystallinity and surface smoothness can be obtained by producing a laminate in accordance with the method as described above. The laminate obtained can be formed into a high quality light emitting device by further depositing crystal layers on the laminate.

### (Manufacture for group III nitride semiconductor)

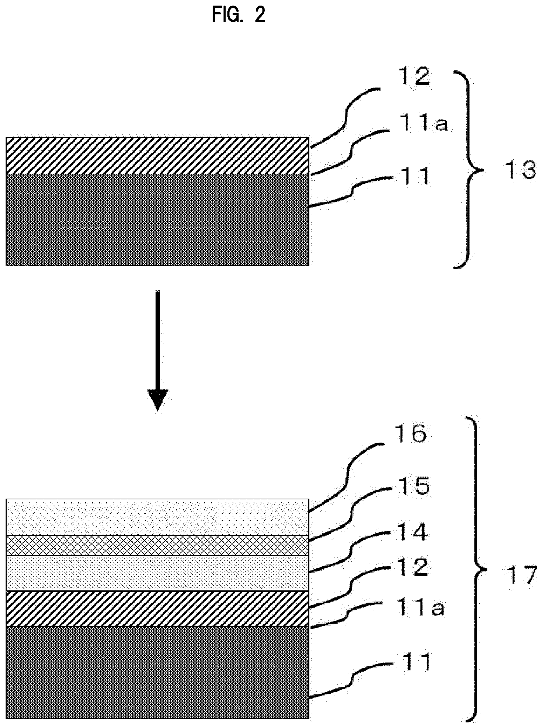

In the method for manufacturing a group III nitride semiconductor, not claimed in the present invention, arbitrary group III nitride single crystal layers are further formed on the group III nitride laminate described above. Fig. 2 is a schematic diagram illustrating one aspect of the process for manufacturing a group III nitride semiconductor according to claim 3, and a group III nitride semiconductor 17 is manufactured by forming an active layer 15 and a p-type layer 16 on the group III nitride laminate 13 as illustrated in Fig. 2. It is also possible to form an n-type layer 14 on the Al_{X}In_{Y}Ga_{Z}N layer (group III nitride single crystal layer 12) if necessary in a case that the Al_{X}In_{Y}Ga_{Z}N layer is an undoped layer.

The optionally formed n-type layer, the active layer, and the p-type layer are all preferably a group III nitride single crystal represented by a composition formula of Al_{A}In_{B}Ga_{C}N (A + B + C = 1.0, 0 ≤ A ≤ 1.0, 0.0 ≤ B ≤ 0.2, and 0.0 ≤ C ≤ 1.0). The composition of each layer is not particularly limited and may be appropriately determined depending on the purpose of use. Incidentally, the active layer has a structure in which a plurality of layers having different compositions are deposited, wherein the layers contain the group III nitride single crystals represented by the above composition formula, but the composition of each layer and the number of layers to be deposited are not particularly limited and may be appropriately set depending on the purpose.

Known elements can be used as dopants of the optionally formed n-type layer and the p-type layer without limitation. For example, it is preferable to use Si as the n-type dopant and Mg as the p-type dopant. In addition, the dopant concentrations in the n-type layer and the p-type layer are not particularly limited and may be appropriately set depending on the purpose. In addition, the group III nitride single crystal layer forming the active layer may be n-type or p-type if necessary, and the dopant species and the dopant concentration are not particularly limited in this case as well.

The optionally formed n-type layer and the p-type layer are not limited to be a single layer and may have a structure in which a plurality of layers having different compositions and dopant concentrations are deposited. In addition, these may be graded composition layers of which the compositions and dopant concentrations continuously change.

The film thicknesses of the optionally formed n-type layer, the active layer and the p-type layer are not particularly limited, and may be appropriately determined depending on the purpose, but it is preferable that the film thicknesses are in the ranges to lattice-match with the aluminum nitride single crystal substrate in a case that an aluminum nitride single crystal substrate is used as the base substrate. The specific film thickness varies depending on the composition of the layer to be formed, but generally it is usually less than 10 µm and preferably 0.01 µm or more and 5 µm or less.

It is preferable that the n-type layer, the active layer, and the p-type layer are smooth. Particularly, it is preferable that the respective layers forming the active layer are smooth since the active layer has such structure that a plurality of thin films are laminated, and the steepness of the interface between the respective layers greatly affects the characteristics of the light emitting device. In addition, the surface shape of the active layer is affected by the surface shape of the n-type layer since the active layer is formed on the n-type layer. Hence, it is required to fabricate a smooth n-type layer in order to fabricate a smooth active layer. In addition, it is preferable that the p-type layer is also smooth since the smoothness of the p-type layer affects the contact resistance between the p-type layer and the electrode to be formed on the surface of the p-type layer. Specifically, the RMS in a region of 2 × 2 µm² of the respective layers measured by using an atomic force microscope is preferably 5 nm or less, more preferably 1 nm or less, and still more preferably 0.5 nm or less.

The growth method of the optionally formed n-type layer, the active layer and the p-type layer is not particularly limited, but it is preferable to subsequently perform the growth of these layers by the same method after the step of growing the Al_{X}In_{Y}Ga_{Z}N layer on the base substrate, and it is preferable to adopt the MOCVD method in the same manner as the growth of the Al_{X}In_{Y}Ga_{Z}N layer. In the case of adopting the MOCVD method, the crystal growth conditions such as growth temperature, pressure, and kinds of raw material gas and carrier gas are not particularly limited and may be appropriately set depending on the group III nitride semiconductor desired.

Incidentally, in a case that the growth of the n-type layer, the active layer, and the p-type layer is not performed subsequently to the growth of the Al_{X}In_{Y}Ga_{Z}N layer, the group III nitride laminate produced may be taken out of the reactor and, at this time, the surface of the group III nitride laminate may be subjected to surface treatments such as polishing, cleaning, and etching by known techniques.

The V/III ratio when growing the n-type layer, the active layer, and the p-type layer is not particularly limited and may be appropriately set depending on the group III nitride semiconductor desired.

A high quality light emitting device can be manufactured by manufacturing a group III nitride semiconductor in accordance with the method as described above and further forming an electrode and the like thereon.

### EXAMPLES

Hereinafter, the invention will be described in detail with reference to Examples and Comparative Examples, but the invention is not limited to the following Examples.

### (Preparation of base substrate)

The base substrates used in Examples 1 to 4 and Comparative Examples 1 to 3 were prepared by the following method.

As the base substrate for growing a group III nitride single crystal layer, an aluminum nitride single crystal substrate fabricated by a sublimation method was used. The size of the base substrate was a square shape of 7 mm × 7 mm, and the thickness was 500 µm. In addition, the main surface of the base substrate to be subjected to crystal growth was polished by chemical mechanical polish, and the RMS in a region of 5 × 5 µm² measured by using an atomic force microscope was 0.1 nm. In addition, the off angle of the base substrate was 0.1°.

The base substrate was cleaned before being subjected to crystal growth. First, the base substrate was immersed in a solution for 10 minutes, which was prepared by mixing sulfuric acid and phosphoric acid at a ratio of 3 : 1 and heated to 90°C to remove the surface oxide film. Thereafter, scrub cleaning of the substrate surface was performed in order to remove foreign matters attached on the surface. After scrub cleaning, the base substrate was cleaned with ultrapure water, the moisture was substituted with isopropyl alcohol, and then the base substrate was dried using a spin coater.

The base substrate after cleaning was placed on the susceptor in a MOCVD apparatus, heated to 1260°C while allowing a hydrogen gas to flow at a flow rate of 8.5 slm, and maintained at this temperature for 10 minutes, thereby performing thermal cleaning of the surface of the base substrate. Incidentally, the substrate temperature was measured by using the in-situ monitor installed in the MOCVD apparatus.

### (Production of group III nitride laminate)

### Example 1

Subsequently, an Al_{X}In_{Y}Ga_{Z}N layer (n-type Al_{X}Ga_{Z}N layer (X = 0.93, Z = 0.07, and Y = 0.00) (group III nitride single crystal layer)) was grown by 140 nm under the conditions that the temperature of the base substrate prepared by the above method was 1070°C, the flow rate of trimethylaluminum was 4.4 µmol/min, the flow rate of trimethylgallium was 1.8 µmol/min, the flow rate of tetraethylsilane was 0.011 µmol/min, the flow rate of ammonia was 1.5 slm, the V/III ratio was 10784, the flow rate of hydrogen carrier gas was 8.3 slm, and the pressure was 50 mbar. At this time, the growth rate of the n-type Al_{X}Ga_{1-X}N layer (X = 0.93, Z = 0.07, and Y = 0.00 (group III nitride single crystal layer)) measured by using the in-situ monitor was 0.14 µm/h. The RMS in 2 × 2 µm² of the n-type Al_{X}Ga_{1-X}N layer (X = 0.93, Z = 0.07, and Y = 0.00 (group III nitride single crystal layer)) after being grown measured by using an atomic force microscope was 0.09 nm. In addition, the state (smoothness) of the surface (main surface) observed under an atomic force microscope was evaluated according to the following three ranks. As a result, the surface was in a favorable state (Rank A). These results and the growth conditions of the Al_{X}In_{Y}Ga_{Z}N layer (n-type AlxGazN layer (X = 0.93, Z = 0.07, and Y = 0.00) (group III nitride single crystal layer)) are summarized in Table 1.

Excellent (S); a state in which minute undulations are not observed on the surface at all under an atomic force microscope (field of vision: 2 × 2 µm²) and atomic steps are uniformly formed.

Favorable (A); a state in which minute undulations are not observed on the surface at all under an atomic force microscope (field of vision: 2 × 2 µm²) but gentle slope in the atomic steps and roughness at the step edges are observed (a state in which there is distortion in the directionality of atomic steps or an uneven structure is formed at the atomic step edges).

Inferior (F); a state in which minute undulations (island-shaped undulations) are observed on the surface under an atomic force microscope (field of vision: 2 × 2 µm²).

### Example 2

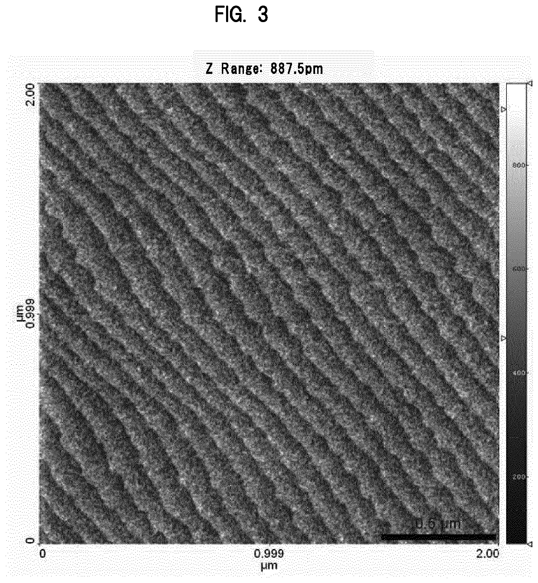

An Al_{X}In_{Y}Ga_{Z}N layer (n-type Al_{X}Ga_{Z}N layer (X = 0.93, Z = 0.07, and Y = 0.00) (group III nitride single crystal layer)) was grown by 680 nm by the same method as in Example 1 except that the flow rate of trimethylaluminum was 8.8 µmol/min, the flow rate of trimethylgallium was 2.2 µmol/min, the flow rate of tetraethylsilane was 0.0055 µmol/min, and the V/III ratio was 6046. At this time, the growth rate of the n-type Al_{X}Ga_{1-X}N layer (X = 0.93, Z = 0.07, and Y = 0.00 (group III nitride single crystal layer)) measured by using the in-situ monitor was 0.28 µm/h. The RMS in 2 × 2 µm² of the n-type Al_{X}Ga_{1-X}N layer (X = 0.93, Z = 0.07, and Y = 0.00 (group III nitride single crystal layer)) after being grown measured by using an atomic force microscope was 0.13 nm. A diagram representing the surface morphology in 2 × 2 µm² observed under an atomic force microscope is illustrated in Fig. 3. In addition, the state of the surface (main surface) observed under an atomic force microscope was evaluated according to the three ranks in the same manner as in Example 1. As a result, the surface was in an excellent state (S). These results and the growth conditions of the Al_{X}In_{Y}Ga_{Z}N layer (n-type AlxGazN layer (X = 0.93, Z = 0.07, and Y = 0.00) (group III nitride single crystal layer)) are summarized in Table 1.

### Example 3

An Al_{X}In_{Y}Ga_{Z}N layer (n-type Al_{X}Ga_{Z}N layer (X = 0.89, Z = 0.11, and Y = 0.00) (group III nitride single crystal layer)) was grown by 280 nm by the same method as in Example 1 except that the flow rate of trimethylaluminum was 8.8 µmol/min, the flow rate of trimethylgallium was 3.1 µmol/min, the flow rate of tetraethylsilane was 0.0055 µmol/min, and the V/III ratio was 5594. At this time, the growth rate of the n-type Al_{X}Ga_{1-X}N layer (X = 0.89, Z = 0.11, and Y = 0.00 (group III nitride single crystal layer)) measured by using the in-situ monitor was 0.28 µm/h. The RMS in 2 × 2 µm² of the n-type Al_{X}Ga_{1-X}N layer (X = 0.89, Z = 0.11, and Y = 0.00 (group III nitride single crystal layer)) after being grown measured by using an atomic force microscope was 0.12 nm. In addition, the state of the surface (main surface) observed under an atomic force microscope was evaluated according to the three ranks in the same manner as in Example 1. As a result, the surface was in an excellent state (S). These results and the growth conditions of the Al_{X}In_{Y}Ga_{Z}N layer (n-type AlxGazN layer (X = 0.89, Z = 0.11, and Y = 0.00) (group III nitride single crystal layer)) are summarized in Table 1.

### Comparative Example 1

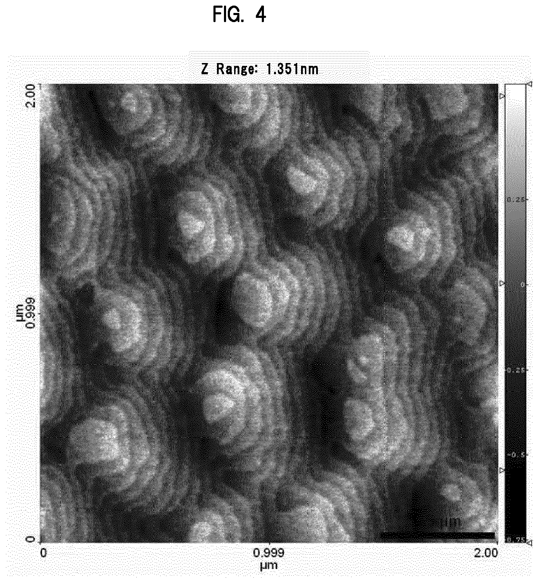

An Al_{X}In_{Y}Ga_{Z}N layer (n-type AlₓGa₁₋ₓN layer (X = 0.94, Z = 0.06, and Y = 0.00) (group III nitride single crystal layer)) was grown by 550 nm by the same method as in Example 1 except that the flow rate of trimethylaluminum was 17.7 µmol/min, the flow rate of trimethylgallium was 2.2 µmol/min, the flow rate of tetraethylsilane was 0.014 µmol/min, and the V/III ratio was 3363. At this time, the growth rate of the n-type Al_{X}Ga_{1-X}N layer (X = 0.94, Z = 0.06, and Y = 0.00 (group III nitride single crystal layer)) measured by using the in-situ monitor was 0.55 µm/h. The RMS in 2 × 2 µm² of the n-type Al_{X}Ga_{1-X}N layer (X = 0.94, Z = 0.06, and Y = 0.00 (group III nitride single crystal layer)) after being grown measured by using an atomic force microscope was 0.20 nm. A diagram representing the surface morphology in 2 × 2 µm² observed under an atomic force microscope is illustrated in Fig. 4. In addition, the state of the surface (main surface) observed under an atomic force microscope was evaluated according to the three ranks in the same manner as in Example 1. As a result, the surface was in an inferior state (F). These results and the growth conditions of the Al_{X}In_{Y}Ga_{Z}N layer (n-type Al_{X}Ga_{Z}N layer (X = 0.94, Z = 0.06, and Y = 0.00) (group III nitride single crystal layer)) are summarized in Table 1.

### Comparative Example 2

An Al_{X}In_{Y}Ga_{Z}N layer (n-type AlₓGa₁₋ₓN layer (X = 0.93, Z = 0.07, and Y = 0.00) (group III nitride single crystal layer)) was grown by 870 nm by the same method as in Example 1 except that the flow rate of trimethylaluminum was 35.3 µmol/min, the flow rate of trimethylgallium was 3.1 µmol/min, the flow rate of tetraethylsilane was 0.028 µmol/min, and the V/III ratio was 1740. At this time, the growth rate of the n-type Al_{X}Ga_{1-X}N layer (X = 0.93, Z = 0.07, and Y = 0.00 (group III nitride single crystal layer)) measured by using the in-situ monitor was 0.87 µm/h. The RMS in 2 × 2 µm² of the n-type Al_{X}Ga_{1-X}N layer (X = 0.93, Z = 0.07, and Y = 0.00 (group III nitride single crystal layer)) after being grown measured by using an atomic force microscope was 0.29 nm. In addition, the state of the surface (main surface) observed under an atomic force microscope was evaluated according to the three ranks in the same manner as in Example 1. As a result, the surface was in an inferior state (F). These results and the growth conditions of the Al_{X}In_{Y}Ga_{Z}N layer (n-type AlxGazN layer (X = 0.93, Z = 0.07, and Y = 0.00) (group III nitride single crystal layer)) are summarized in Table 1.

**[Table 1]**

| | Composition and growth condition of AlₓGa₁₋ₓN layer (group III nitride single crystal layer) | | | Surface state of AlₓGa₁₋ₓN layer (group III nitride single crystal layer) | |
|---|---|---|---|---|---|
| | AI composition (X) | V/III ratio | Growth rate (µm/h) | RMS (nm) | Smoothness |
| Example 1 | 0.93 | 10780 | 0.14 | 0.09 | A |
| Example 2 | 0.93 | 6050 | 0.28 | 0.13 | S |
| Example 3 | 0.89 | 5594 | 0.28 | 0.12 | S |
| Comparative Example 1 | 0.94 | 3360 | 0.55 | 0.20 | F |
| Comparative Example 2 | 0.93 | 1740 | 0.87 | 0.29 | F |

From the surface morphology diagram of the group III nitride laminate fabricated in Comparative Example 1 illustrated in Fig. 4, it can be seen that the surface of the laminate has a shape with minute undulations and the smoothness is poor. On the other hand, from the surface morphology diagram of the group III nitride laminate fabricated in Example 2 illustrated in Fig. 3, it can be seen that minute undulations as observed in Fig. 4 are not observed, uniform atomic steps are formed, and crystal growth has proceeded in the FM mode. It is possible to produce a group III nitride laminate having a smooth surface by setting the V/III ratio to a specific value or more.

### (Manufacture for group III nitride semiconductor)

In a case that the group III nitride semiconductor is manufactured by the method of the invention, it is the most effective for the characteristics of a light emitting device that the smoothness of the respective layers forming the active layer is improved and the steepness of the interface is improved. Accordingly, in Example 4 and Comparative Example 3 as described below, manufacturing examples of the group III nitride semiconductor in which an active layer is grown on a laminate obtained by growing a group III nitride single crystal layer on a base substrate are described.

### Example 4

### (Formation of Al_{X}In_{Y}Ga_{Z}N layer (group III nitride single crystal layer))

An Al_{X}In_{Y}Ga_{Z}N layer (n-type Al_{X}Ga_{1-X}N layer (X = 0.93, Z = 0.07, and Y = 0.00) (group III nitride single crystal layer)) was grown by 570 nm using the same base substrate as that used in Example 1 under the conditions that the temperature of the base substrate was 1070°C, the flow rate of trimethylaluminum was 8.8 µmol/min, the flow rate of trimethylgallium was 2.2 µmol/min, the flow rate of tetraethylsilane was 0.0055 µmol/min, the flow rate of ammonia was 1.5 slm, the V/III ratio was 6046, the flow rate of hydrogen carrier gas was 8.3 slm, and the pressure was 50 mbar. At this time, the growth rate of the n-type Al_{X}Ga_{1-X}N layer (X = 0.93, Z = 0.07, and Y = 0.00 (group III nitride single crystal layer)) measured by using the in-situ monitor was 0.28 µm/h.

### (Formation of active layer)

Subsequently, an Al_{A}Ga_{c}N layer (A = 0.93, C = 0.07, B = 0.00) was grown by 7 nm as a barrier layer under the conditions that the temperature of the base substrate was 1070°C, the flow rate of trimethylaluminum was 22.1 µmol/min, the flow rate of trimethylgallium was 3.1 µmol/min, the flow rate of ammonia was 1.5 slm, the V/III ratio was 2655, the flow rate of hydrogen carrier gas was 8.3 slm, and the pressure was 50 mbar.

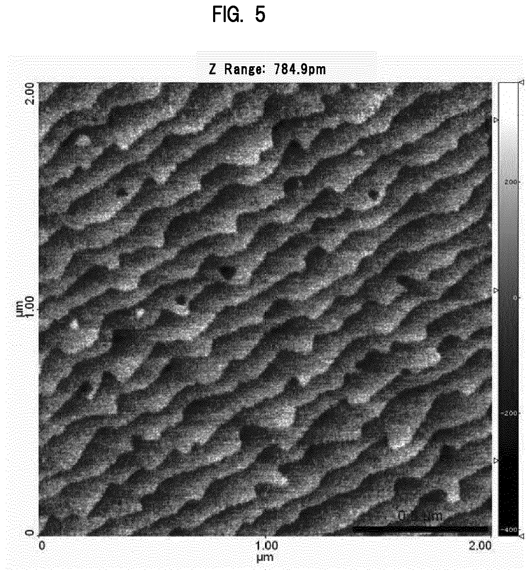

Subsequently, an Al_{A}Ga_{c}N layer (A = 0.90, C = 0.1, B = 0.0) was grown by 10 nm as a well layer under the conditions that the temperature of the base substrate was 1070°C, the flow rate of trimethylaluminum was 22.1 µmol/min, the flow rate of trimethylgallium was 4.5 µmol/min, the flow rate of ammonia was 1.5 slm, the V/III ratio was 2521, the flow rate of hydrogen carrier gas was 8.3 slm, and the pressure was 50 mbar. Three barrier layers and three well layers were alternately grown under the same conditions as those described above, and then a barrier layer was grown by 20 nm under the same conditions as those described above. The RMS in 2 × 2 µm² of the barrier layer after being grown measured by using an atomic force microscope was 0.11 nm. A diagram representing the surface morphology in 2 × 2 µm² observed under an atomic force microscope is illustrated in Fig. 5.

### Comparative Example 3

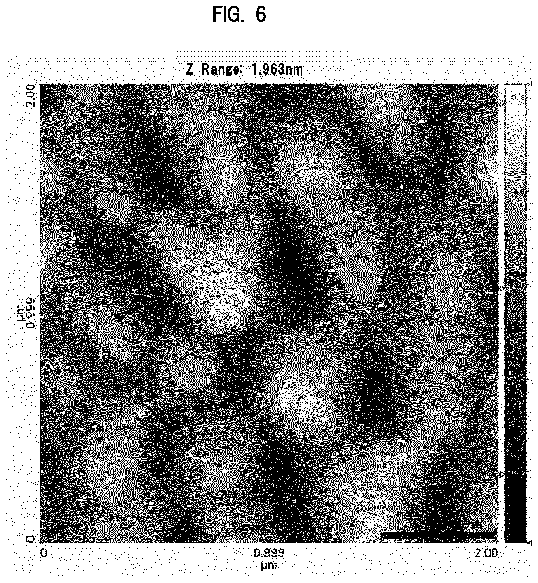

A group III nitride semiconductor was fabricated by the same method as in Example 4 except that the flow rate of trimethylaluminum was 35.3 µmol/min, the flow rate of trimethylgallium was 3.1 µmol/min, the flow rate of tetraethylsilane was 0.028 µmol/min, the V/III ratio was 1740, and grown film thickness was 2020 µm in the growth conditions of the Al_{X}In_{Y}Ga_{Z}N layer (n-type Al_{X}Ga_{1-X}N layer (X = 0.93, Z = 0.07, and Y = 0.00) (group III nitride single crystal layer)) in the (formation of Al_{X}In_{Y}Ga_{Z}N layer (group III nitride single crystal layer)) of Example 4. The RMS in 2 × 2 µm² of the barrier layer after being grown measured by using an atomic force microscope was 0.27 nm. A diagram representing the surface morphology in 2 × 2 µm² observed under an atomic force microscope is illustrated in Fig. 6.

In each of Example 4 and Comparative Example 3, the active layer was grown under the same growth conditions after growth of the n-type Al_{X}Ga_{1-X}N layers (x = 0.93 (group III nitride single crystal layers)) described in Example 2 and Comparative Example 2 respectively. From the surface morphology diagram illustrated in Fig. 6, it can be seen that the surface of the group III nitride semiconductor fabricated in Comparative Example 3 has minute undulations and exhibits inferior smoothness. On the other hand, from the surface morphology diagram illustrated in Fig. 5, it can be seen that such a minute undulation shape is not observed and the surface of the group III nitride semiconductor fabricated in Example 4 is smooth. It is considered that this difference in smoothness of the active layers is the difference in smoothness of the n-type Al_{X}Ga_{1-X}N layers (x = 0.93 (group III nitride single crystal layers)) to be the ground of the active layer since the growth conditions of the active layers in Example 4 and Comparative Example 3 are the same as each other, and it is indicated that the group III nitride semiconductor having a smoother surface and excellent interface steepness is obtained by using the group III nitride laminate having a smoother surface.

### EXPLANATIONS OF LETTERS OR NUMERALS

- 11: Base Substrate
- 11a: Main Surface Containing Aluminum Nitride Single Crystal (Aluminum Nitride Single Crystal Surface) Of Base Substrate
- 12: Group III Nitride Single Crystal Layer (Al_{X}In_{Y}Ga_{Z}N Layer)
- 13: Group III Nitride Laminate
- 14: N-Type Layer
- 15: Active Layer
- 16: P-Type Layer
- 17: Group III Nitride Semiconductor

## Claims

1. A method for producing a group III nitride laminate (13) by a MOCVD method with supplying a group III raw material gas and a nitrogen source gas onto a main surface (11a) of an aluminum nitride single crystal substrate (11) and growing a layer (12) containing a group III nitride single crystal represented by Al_{X}In_{Y}Ga_{Z}N, where X, Y, and Z in the composition formula satisfy relation of X + Y + Z = 1.0, 0.85 ≤ X < 0.99, 0.00 ≤ Y < 0.14, and 0.01 < Z ≤ 0.15, onto said main surface (11a) of said aluminum nitride single crystal substrate (11),
wherein a surface of the layer (12) containing the group III nitride single crystal has a root-mean-square roughness (RMS) in a region of 2 × 2 µm² of 0.5 nm or less measured by using an atomic force microscope, and wherein
the group III raw material gas is at least one selected from the group consisting of trimethylaluminum, trimethylgallium, and trimethylindium, and the nitrogen source gas is ammonia,
a growth temperature when growing the layer (12) containing the group III nitride single crystal is set to 1000°C or more and 1200°C or less,
a growth rate when growing the layer (12) containing the group III nitride single crystal is set to 0.1 µm/h or more and 0.5 µm/h or less, and
a V/III ratio representing a molar ratio of the nitrogen source gas to the group III raw material gas is set to 5000 or more and 15000 or less.

2. The method for producing a group III nitride laminate (13) according to claim 1, wherein the layer (12) containing the group III nitride single crystal contains a dopant.

3. A method for manufacturing a group III nitride semiconductor (17), comprising producing a group III nitride laminate (13) by the method according to claim 1 or 2 and then forming at least an active layer (15) and a p-type layer (16) on the group III nitride single crystal layer (12).

## Patentansprüche

1. Verfahren zum Herstellen eines Gruppe-III-Nitridlaminats (13) durch ein MOCVD-Verfahren mit Zuführen eines Gruppe-III-Rohmaterialgases und eines Stickstoffquellegases auf eine Hauptoberfläche (11a) eines Aluminiumnitrideinkristallsubstrats (11) und Züchten einer Schicht (12), die einen Gruppe-III-Nitrideinkristall enthält, der durch Al_{X}In_{Y}Ga_{Z}N dargestellt ist, wobei X, Y und Z in der Zusammensetzungsformel die Beziehung X + Y + Z = 1,0, 0,85 ≤ X < 0,99, 0,00 ≤ Y < 0,14 und 0,01 < Z ≤ 0,15 erfüllen, auf der Hauptoberfläche (11a) des Aluminiumnitrideinkristallsubstrats (11),
wobei eine Oberfläche der Schicht (12), die den Gruppe-III-Nitrideinkristall enthält, einen quadratischen Mittelwert der Rauheit (RMS) in einem Bereich von 2 × 2 µm² von 0,5 nm oder weniger aufweist, gemessen unter Verwendung eines Rasterkraftmikroskops, und wobei
das Gruppe-III-Rohmaterialgas mindestens ein Gas ist, das aus der Gruppe ausgewählt ist, die aus Trimethylaluminium, Trimethylgallium und Trimethylindium besteht, und das Stickstoffquellegas Ammoniak ist,
eine Züchtungstemperatur beim Züchten der Schicht (12), die den Gruppe-III-Nitrideinkristall enthält, auf 1000 °C oder mehr und 1200 °C oder weniger eingestellt wird,
eine Züchtungsrate beim Züchten der Schicht (12), die den Gruppe-III-Nitrideinkristall enthält, auf 0,1 µm/h oder mehr und 0,5 µm/h oder weniger eingestellt wird, und
ein V/III-Verhältnis, das ein Molverhältnis des Stickstoffquellegases zu dem Gruppe-III-Rohmaterialgas darstellt, auf 5000 oder mehr und 15000 oder weniger eingestellt wird.

2. Verfahren zum Herstellen eines Gruppe-III-Nitridlaminats (13) nach Anspruch 1, wobei die Schicht (12), die den Gruppe-III-Nitrideinkristall enthält, ein Dotiermittel enthält.

3. Verfahren zum Fertigen eines Gruppe-III-Nitridhalbleiters (17), das das Herstellen eines Gruppe-III-Nitridlaminats (13) durch das Verfahren nach Anspruch 1 oder 2 und dann das Bilden mindestens einer aktiven Schicht (15) und einer p-Typ-Schicht (16) auf der Gruppe-III-Nitrideinkristallschicht (12) umfasst.

## Revendications

1. Procédé pour produire un stratifié de nitrure du groupe III (13) par un procédé MOCVD en fournissant un gaz de matière première du groupe III et un gaz source d'azote sur une surface principale (11a) d'un substrat monocristallin de nitrure d'aluminium (11) et en faisant croître une couche (12) contenant un monocristal de nitrure du groupe III représenté par Al_{X}In_{Y}Ga_{Z}N, où X, Y et Z dans la formule de composition satisfont à la relation X + Y + Z = 1,0, 0,85 ≤ X < 0,99, 0,00 ≤ Y < 0,14 et 0,01 < Z ≤ 0,15, sur ladite surface principale (11a) dudit substrat monocristallin de nitrure d'aluminium (11),
dans lequel une surface de la couche (12) contenant le monocristal de nitrure du groupe III a une rugosité quadratique moyenne (RMS) dans une région de 2 × 2 µm² de 0,5 nm ou moins mesurée en utilisant un microscope à force atomique, et dans lequel
le gaz de matière première du groupe III est au moins l'un choisi dans le groupe constitué par le triméthylaluminium, le triméthylgallium et le triméthylindium, et le gaz source d'azote est l'ammoniac,
une température de croissance lors de la croissance de la couche (12) contenant le monocristal de nitrure du groupe III est définie à 1 000 °C ou plus et 1 200 °C ou moins,
un taux de croissance lors de la croissance de la couche (12) contenant le monocristal de nitrure du groupe III est défini à 0,1 µm/h ou plus et 0,5 µm/h ou moins, et
un taux V/III représentant un taux molaire du gaz source d'azote au gaz de matière première du groupe III est défini à 5 000 ou plus et 15 000 ou moins.

2. Procédé pour produire un stratifié de nitrure du groupe III (13) selon la revendication 1, dans lequel la couche (12) contenant le monocristal de nitrure du groupe III contient un dopant.

3. Procédé pour fabriquer un semi-conducteur au nitrure du groupe III (17), comprenant la production d'un stratifié de nitrure du groupe III (13) par le procédé selon la revendication 1 ou 2 et ensuite la formation d'au moins une couche active (15) et d'une couche de type p (16) sur la couche de monocristal de nitrure du groupe III (12).
